# EUROPÄISCHE PATENTSCHRIFT

(11) **EP 2 619 811 B1**
(45) Veröffentlichungstag und Bekanntmachung des Hinweises auf die Patenterteilung: **24.06.2015**
(21) Anmeldenummer: 11754331.4
(22) Anmeldetag: 22.08.2011
(51) Int. Cl.: H01L 35/08, H01L 35/32

(54) **HALBLEITERELEMENT FÜR EIN THERMOELEKTRISCHES MODUL**
SEMICONDUCTOR ELEMENT FOR A THERMOELECTRIC MODULE
ELEMENT SEMICONDUCTEUR POUR UN MODULE THERMOELECTRIQUE

(30) Priorität: 23.08.2010 DE 102010035151
(43) Veröffentlichungstag der Anmeldung: 31.07.2013
(73) Patentinhaber: Emitec Gesellschaft für Emissionstechnologie mbH, 53797 Lohmar (DE)
(72) Erfinder: BRÜCK, Rolf, 51429 Bergisch Gladbach (DE)
(74) Vertreter: Rössler, Matthias
(86) Internationale Anmeldenummer: PCT/EP2011/064350
(87) Internationale Veröffentlichungsnummer: WO 2012/025475

(56) Entgegenhaltungen:
- US-A- 3 054 840
- US-A- 3 201 504
- US-A- 3 261 079
- US-A- 3 304 206
- US-A- 3 547 706
- US-A- 3 859 143
- US-A- 3 988 171
- US-A- 5 429 680

## Beschreibung

Die vorliegende Erfindung betrifft ein Halbleiterelement, und ein thermoelektrisches Modul, das ein solches Halbleiterelement aufweist.

Das Abgas aus einer Verbrennungskraftmaschine eines Kraftfahrzeugs besitzt thermische Energie, welche mittels eines thermoelektrischen Generators in elektrische Energie umgewandelt werden kann, bspw. um eine Batterie oder einen anderen Energiespeicher zu füllen und/oder elektrischen Verbrauchern die benötigte Energie direkt zuzuführen. Damit wird das Kraftfahrzeug mit einem besseren energetischen Wirkungsgrad betrieben, und es steht für den Betrieb des Kraftfahrzeugs Energie in größerem Umfang zur Verfügung.

Ein solcher thermoelektrischer Generator weist zumindest ein thermoelektrisches Modul auf. Thermoelektrische Module umfassen z. B. wenigstens zwei Halbleiterelemente (p- und n-dotiert), die auf ihrer Ober- und Unterseite (hin zur Heißseite bzw. Kaltseite) wechselseitig mit elektrisch leitenden Brücken versehen sind und die die kleinste thermoelektrische Einheit bzw. ein thermoelektrisches Element bilden. Thermoelektrische Materialien sind von einer Art, dass diese effektiv thermische Energie in elektrische Energie umwandeln können (Seebeck-Effekt) und umgekehrt (Peltier-Effekt). Wird ein Temperaturgefälle beidseits der Halbleiterelemente bereitgestellt, so bildet sich zwischen den Enden der Halbleiterelemente ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind bevorzugt zahlreiche Halbleiterelemente elektrisch in Reihe geschaltet. Damit sich die generierten Potentialdifferenzen der seriellen Halbleiterelemente nicht gegenseitig aufheben, sind stets wechselweise Halbleiterelemente mit unterschiedlichen Majoritätsladungsträgern (n- und p-dotiert) in direkten elektrischen Kontakt gebracht. Mittels eines angeschlossenen Lastwiderstands kann der Stromkreis geschlossen und somit elektrische Leistung abgegriffen werden.

Um eine dauerhafte Einsatzfähigkeit der Halbleiterelemente zu gewährleisten, wird zwischen den elektrisch leitenden Brücken und dem thermoelektrischen Material regelmäßig eine Diffusionsbarriere angeordnet, die ein Diffundieren von in den elektrischen Brücken enthaltenem Material in das thermoelektrische Material verhindert und damit einem Effektivitätsverlust bzw. ein funktionelles Versagen des Halbleitermaterials bzw. des thermoelektrischen Elements verhindert. Der Aufbau von thermoelektrischen Modulen bzw. der Halbleiterelemente erfolgt üblicherweise durch den Zusammenbau der einzelnen Komponenten thermoelektrisches Material, Diffusionsbarriere, elektrisch leitende Brücken, Isolierung und ggf. weiteren Gehäuseelementen zu einem thermoelektrischen Modul, das von einem heißen bzw. kalten Medium überströmt wird. Dieser Zusammenbau zahlreicher einzelner Komponenten erfordert auch eine genaue Abstimmung der einzelnen Bauteiltoleranzen und eine Berücksichtigung der Wärmeübergänge von der Heißseite zur Kaltseite sowie der hinreichenden Kontaktierung der elektrisch leitenden Brücken, so dass ein Stromfluss durch das thermoelektrische Modul erzeugt werden kann.

Die US 3,547,706 betrifft ein zylinderförmiges thermoelektrisches Material, das an seinen jeweiligen Stirnseiten einen diffusionshemmenden Anschluss aufweist. Dieser Anschluss umfasst das thermoelektrische Material stirnseitig, wobei zwischen der Aufnahme und dem thermoelektrischen Material zusätzlich ein Lotmaterial zur Verbindung eingesetzt werden kann.

Aus der US 3,261,079 ist ein Verfahren zur Herstellung eines thermoelektrischen Elements bekannt, wobei das thermoelektrische Material mit Diffusionssperrschichten versehen wird.

Ein Verfahren zur pulvermetallurgischen Herstellung von thermoelektrischen Elementen ist aus US 3,201,504 bekannt. Die Elemente werden zusammen mit metallischen Diffusionssperren hergestellt. P- und n-dotierte thermoelektrische Materialien werden über einen gemeinsamen elektrischen Leiter miteinander verbunden.

Die US 3,054,840 offenbart ein rohrförmiges thermoelektrisches Modul, bei dem ringförmige, thermisch leitende Elemente abwechselnd mit der Heiß- und Kaltseite verbunden sind. Zwischen den ringförmigen thermischen Leitern sind ringförmige thermoelektrische Elemente angeordnet, die durch die thermischen Leiter auch elektrisch leitend miteinander verbunden sind.

Hiervon ausgehend ist es Aufgabe der hier vorliegenden Erfindung, die im Bezug auf den Stand der Technik geschilderten Probleme zumindest teilweise zu lösen. Insbesondere soll ein Halbleiterelement angegeben werden, das für vielseitige Einsatzfälle geeignet ist, und das einen möglichst einfachen und kostengünstigen Aufbau eines thermoelektrischen Moduls ermöglicht. Zudem soll ein einfaches Verfahren zur Herstellung eines solchen Halbleiterelements angegeben werden.

Diese Aufgaben werden gelöst mit einem Halbleiterelement gemäß den Merkmalen des Patentanspruchs 1. Vorteilhafte Ausgestaltungen des erfindungsgemäßen Halbleiterelements sowie die Integration dieses Halbleiterelements in übergeordnete Baueinheiten sind in den abhängig formulierten Patentansprüchen angegeben. Die in den Patentansprüchen einzeln aufgeführten Merkmale sind in beliebiger, technologisch sinnvoller, Weise miteinander kombinierbar und zeigen weitere Ausgestaltungen der Erfindung auf. Die Beschreibung, insbesondere im Zusammenhang mit den Figuren, erläutert die Erfindung weiter und führt ergänzende Ausführungsbeispiele der Erfindung an.

Das erfindungsgemäße Halbleiterelement weist zumindest ein thermoelektrisches Material und ein erstes Rahmenteil auf, wobei diese kraftschlüssig miteinander verbunden sind und das erste Rahmenteil eine Diffusionsbarriere für das Halbleiterelement und einen elektrischen Stromleiter bildet. Das Halbleiterelement stellt hier also die kleinste Baueinheit dar und ist bereits mit dem ersten Rahmenteil kraftschlüssig und unverlierbar verbunden. Dafür wird das Material des ersten Rahmenteils so ausgewählt, dass eine Diffusionsbarriere gewährleistet ist und das thermoelektrische Material somit nicht durch hinein diffundierende Elemente verunreinigt und in seiner Effektivität hinsichtlich der Umwandlung von Wärmeenergie in elektrische Energie beeinträchtigt wird. Gleichzeitig stellt das erste Rahmenteil einen elektrischen Stromleiter zur Verfügung, so dass das erste Rahmenteil eines Halbleiterelements auch mit benachbarten Halbleiterelementen oder deren erste Rahmenteilen direkt verbindbar ist und somit ein durch das thermoelektrische Modul erzeugter elektrischer Strom insbesondere ausschließlich durch die Rahmenteile und die Halbleiterelemente des thermoelektrischen Moduls fließt. Insbesondere sind das Halbleiterelement und das erste Rahmenteil miteinander zumindest teilweise formschlüssig oder sogar stoffschlüssig verbunden.

Als thermoelektrisches Material sind insbesondere folgende Werkstoffe einsetzbar:
n-Typ: Bi₂Te₃; PbTe; Ba_{0,3}Co_{3,95}Ni_{0,05}Sb₁₂; Ba_{y}(Co,Ni)₄Sb₁₂; CoSb₃; Ba₈Ga₁₆Ge₃₀; La₂Te₃; SiGe; Mg₂(Si,Sn);
p-Typ: (Bi,Sb)₂Te₃; Zn₄Sb₃; TAGS; PbTe; SnTe; CeFe₄Sb₁₂; Yb₁₄MnSb₁₁; SiGe; Mg₇(Si,Sb).

Die erfindungsgemäße Ausgestaltung des Halbleiterelements sieht ein zweites Rahmenteil für das Halbleiterelement vor, das auf einer Elementfläche des thermoelektrischen Materials angeordnet ist, die der Elementfläche gegenüberliegt, an der das erste Rahmenteil angeordnet ist. Dabei ist das thermoelektrische Material insbesondere nach Art eines Zylinders, Kubus, Barrens und/oder Kreisringsegments ausgeführt, wobei das erste Rahmenteil und das zweite Rahmenteil auf sich gegenüberliegenden Elementflächen des thermoelektrischen Materials angeordnet sind. Alle Ausführungen, die das erste Rahmenteil betreffen, gelten ohne Einschränkung auch für das zweite Rahmenteil und umgekehrt.

Bei der erfindunsgemäßen Ausgestaltung des Halbleiterelements sind das thermoelektrische Material, das erste Rahmenteil und das zweite Rahmenteil ringförmig, wobei das erste Rahmenteil auf einer inneren Umfangsfläche und das zweite Rahmenteil auf einer äußeren Umfangsfläche des thermoelektrischen Materials angeordnet sind. Insbesondere ist durch eine derartige Ausgestaltung ein rohrförmiges thermoelektrisches Modul herstellbar, bei dem die Halbleiterelemente hintereinander angeordnet werden und über erste Rahmenteile und zweite Rahmenteile jeweils wechselweise elektrisch miteinander verbunden sind.

Weiterhin wird vorgeschlagen, dass zumindest das erste Rahmenteil zwei voneinander beabstandete gegenüberliegende Flächen aufweist, wobei eine der Flächen eine dem thermoelektrischen Material zugewandte Anbindungsfläche ist und der Abstand der Flächen voneinander eine Dicke des ersten Rahmenteils definiert und diese Dicke 0,1 mm bis 1 mm [Millimeter], bevorzugt 0,2 bis 0,5 mm, beträgt. Insbesondere sind die durch das thermoelektrische Material voneinander beabstandeten ersten Rahmenteile und zweiten Rahmenteile 1 bis 5 mm [Millimeter] voneinander entfernt, d. h. die Materialstärke des thermoelektrischen Materials beträgt 1 bis 5 mm. Das zweite Rahmenteil kann gegebenenfalls ebenso ausgeführt sein.

Bevorzugt ist weiterhin eine Ausgestaltung, bei der das zweite Rahmenteil aus einem Material einer Festigkeit ausgebildet ist, die größer ist als die Festigkeit des Materials, aus dem das erste Rahmenteil ausgebildet ist.

Gemäß einer weiteren vorteilhaften Ausgestaltung des Halbleiterelements weist zumindest das erste Rahmenteil zwei voneinander beabstandete gegenüberliegende Kontaktflächen auf, deren Abstand eine erste Breite definieren. Dabei ist die erste Breite zumindest teilweise größer als eine zweite Breite des thermoelektrischen Materials, so dass das erste Rahmenteil an zumindest einer Seite des thermoelektrischen Materials übersteht. Die hier genannten Kontaktflächen dienen insbesondere der Kontaktierung von benachbart zueinander angeordneten Halbleiterelementen über deren Rahmenteile. Die Erstreckung des ersten Rahmenteils mit einer ersten Breite und des thermoelektrischen Materials in einer zweiten Breite wird insbesondere in einer parallelen Richtung zueinander betrachtet, so dass durch die Definition, dass die erste Breite zumindest teilweise größer als die zweite Breite ist, klargestellt wird, dass das erste Rahmenteil an zumindest einer Seite des thermoelektrischen Materials über dieses übersteht. Bevorzugt wird dabei das erste Rahmenteil an zumindest einer Seite bündig zu dem thermoelektrischen Material angeordnet. Ganz besonders bevorzugt ist, dass dieser (einzelne) Überstand nur über einen geringen Teil der Erstreckung des ersten Rahmenteils vorgesehen ist, insbesondere nur über 30 % oder sogar nur 20 % der Erstreckung (in Umfangsrichtung). Das zweite Rahmenteil kann gegebenenfalls ebenso ausgeführt sein.

Es kann auch vorgesehen sein, dass zumindest das erste Rahmenteil zusätzlich an zumindest einer weiteren Seite gegenüber dem thermoelektrischen Material übersteht. Eine solche Ausgestaltung ist insbesondere dann vorteilhaft, wenn eine Verbindung der ersten Rahmenteile über die Kontaktflächen erfolgt, so dass es im Falle eines Verschweißens, Verlötens oder Verklebens der Kontaktflächen von nebeneinander angeordneten Halbleiterelementen miteinander nicht zu einer Beschädigung oder Verunreinigung des thermoelektrischen Materials kommt, wodurch die Effektivität hinsichtlich der Umwandlung von Wärmeenergie in elektrische Energie beeinträchtigt werden könnte. Das zweite Rahmenteil kann gegebenenfalls ebenso ausgeführt sein.

Weiterhin kann durch das definierte Überstehen des ersten Rahmenteils gegenüber dem thermoelektrischen Material auch ein Füllgrad eines thermoelektrischen Moduls beeinflusst werden. Der Füllgrad bestimmt hierbei den Anteil des thermoelektrischen Materials an einem Zwischenraum bzw. Volumen zwischen einer Heißseite und einer Kaltseite eines thermoelektrischen Moduls, in dem thermoelektrische Materialien angeordnet sind. Bevorzugt ist hier, dass zumindest die erste Breite mindestens einen Betrag von 130 % der zweiten Breite aufweist, so dass zwischen zwei benachbart zueinander angeordneten thermoelektrischen Materialien ein Spalt besteht, der zumindest 30 % der Materialstärke des thermoelektrischen Materials in dieser Richtung beträgt. Dies kann auch (zusammen) mit den zweiten Rahmenteilen erreicht werden.

Gemäß einer weiteren vorteilhaften Ausgestaltung des Halbleiterelements weist zumindest das erste Rahmenteil eine Beschichtung auf, die zumindest auf der dem thermoelektrischen Material zugewandten Anbindungsfläche angeordnet ist. Das zweite Rahmenteil kann gegebenenfalls ebenso ausgeführt sein. Diese Beschichtung umfasst insbesondere ein Lot und/oder ein Material zur Erhöhung der Verbindungsflächen von thermoelektrischem Material und erstem/zweitem Rahmenteil. Hier muss insbesondere das Lot zusätzlich die Eigenschaften einer Diffusionsbarriere aufweisen, da es zwischen thermoelektrischem Material und erstem/zweitem Rahmenteil angeordnet ist. Durch die Beschichtung wird die Verbindung zwischen dem ersten/zweiten Rahmenteil und thermoelektrischem Material möglich bzw. mit einer möglichst hohen Festigkeit ausgeführt. Somit kann auch die wärmeleitende Kontaktierung zwischen dem erstem/zweitem Rahmenteil und thermoelektrischem Material verbessert werden bzw. sichergestellt sein, so dass die Effektivität des Halbleiterelements bzw. des eine Vielzahl von Halbleiterelementen aufweisenden thermoelektrischen Moduls gewährleistet ist. Eine für diesen Zweck eingesetzte Beschichtung umfasst insbesondere Lot. Bei dem Lot handelt es sich insbesondere um ein bleihaltiges Lot, bevorzugt mit einem Bleianteil von 90 Gewichts-% und mehr.

Weiterhin wird vorgeschlagen, dass zumindest das erste Rahmenteil zumindest auf der dem thermoelektrischen Material zugewandten Anbindungsfläche wenigstens teilweise eine Oberflächenstruktur aufweist, die mindestens eines der folgenden Elemente umfasst:
- Nut,
- Absatz,
- Erhebung,
- Rauhigkeit Rz von mindestens 12 µm.

Durch diese Oberflächenstruktur kommt es insbesondere zu einem Formschluss von thermoelektrischem Material über das mindestens eine Element hin zu dem ersten Rahmenteil. Durch das Element wird die Verbindung zwischen thermoelektrischem Material und dem ersten Rahmenteil hinsichtlich der Verbindungsfestigkeit verbessert. Das zweite Rahmenteil kann gegebenenfalls ebenso ausgeführt sein.

Eine Nut umfasst hier eine Vertiefung innerhalb des ersten Rahmenteils, die sich von einem Absatz dahingehend unterscheidet, dass bei einem (umlaufenden) Absatz die Vertiefung sich bis zu einer Kontaktfläche erstreckt, so dass das erste Rahmenteil auf ein thermoelektrisches Material aufschiebbar wäre. Die hier angegebene Erhebung ist im Gegensatz zu der Nut und dem Absatz ein Fortsatz des Rahmenteils, der sich in das thermoelektrische Material hinein erstreckt und damit einen Formschluss zwischen thermoelektrischem Material und dem erstem Rahmenteil ermöglicht.

Die hier definierte Rauhigkeit Rz wird üblicherweise nach DIN 4768 ermittelt, wobei hier ein Wert von zumindest 12 µm [Mikrometer], insbesondere zumindest 20 µm vorliegt, so dass eine große Oberfläche zur Verbindung von thermoelektrischem Material und erstem Rahmenteil vorliegt.

Gemäß einer weiteren vorteilhaften Ausgestaltung des Halbleiterelements besteht zumindest das erste Rahmenteil zu mindestens 95 Massen-% aus Nickel oder aus Molybdän. Diese Materialien gewährleisten, dass das erste Rahmenteil einerseits sicher eine Diffusionsbarriere gegenüber dem thermoelektrischen Material bildet, und weiter dazu geeignet ist, einen elektrischen Stromleiter zu realisieren. Insbesondere ist hier vorgesehen, dass das erste Rahmenteil zu mindestens 99 Massen-% aus Nickel oder aus Molybdän besteht. Das zweite Rahmenteil kann gegebenenfalls ebenso ausgeführt sein.

Es wird ergänzend ein Verfahren zur Herstellung eines Halbleiterelements vorgestellt, das zumindest die folgenden Schritte ausweist:
a) Bereitstellen zumindest eines ersten Rahmenteils,
b) Anordnen eines thermoelektrischen Materials an einer Anbindungsfläche des ersten Rahmenteils,
c) Verpressen zumindest des ersten Rahmenteils und des thermoelektrischen Materials, so dass die beiden eine kraftschlüssige Verbindung eingehen.

Das Verfahren ist insbesondere geeignet zur Herstellung eines hier erfindungsgemäß beschriebenen Halbleiterelements.

Die einzelnen Schritte werden regelmäßig in der hier angegebenen Reihenfolge ausgeführt, wobei ggf. mehrere Halbleiterelemente gemeinsam hergestellt werden können. Im Hinblick auf das Verfahren ist anzumerken, dass in Schritt a) ggf. auch ein zweites Rahmenteil bereitgestellt werden kann, so dass dann in Schritt b) das thermoelektrische Material zwischen den Anbindungsflächen beider Rahmenteile angeordnet und danach mit diesen verpresst wird.

Gemäß einer besonders vorteilhaften Ausgestaltung des Verfahrens liegt das thermoelektrische Material in Schritt b) pulverförmig vor oder ist bereits vorgepresst.

Bevorzugt ist eine Ausgestaltung des Verfahrens, bei der der vorgepresste Rohling eine Porosität von 20 % und weniger, bevorzugt eine Porosität von 10 % und weniger, und besonders bevorzugt eine Porosität von 5 % und weniger aufweist.

Durch das Verpressen zumindest des ersten Rahmenteils (sowie ggf. des zweiten Rahmenteiles) und des thermoelektrischen Materials wird zumindest eine kraftschlüssige Verbindung erzeugt. Insbesondere kann durch zusätzliche Elemente wie eine Nut, ein Absatz, eine Erhebung und/oder eine erhöhte Rauhigkeit des ersten/zweiten Rahmenteils auch eine formschlüssige Verbindung erreicht werden. Eine stoffschlüssige Verbindung ist ebenfalls insbesondere zusätzlich möglich und wird durch eine Beschichtung zwischen dem ersten/zweiten Rahmenteil und dem thermoelektrischen Material erreicht, insbesondere durch Einsatz eines Lotwerkstoffes. Durch das Verpressen wird insbesondere das thermoelektrische Material weiter verdichtet und fließt in Richtung des ersten Rahmenteils, so dass die vorgesehenen Elemente zur Erhöhung der Verbindungsfestigkeit zwischen zumindest erstem Rahmenteil und thermoelektrischem Material voll ausgefüllt werden.

Besonders bevorzugt ist eine Verfahrensführung, bei der die verpressten Elemente, also insbesondere das erste Rahmenteil und das thermoelektrische Material, nach dem Verpressen eine Porosität von 10 % und weniger, insbesondere 5 % und weniger, und besonders bevorzugt 3 % und weniger aufweist. Bevorzugt wird das Verpressen über die Prozessparameter Pressdruck, Presszeit und/oder Presstemperatur gesteuert. Es ist bevorzugt möglich, den Verfahrensschritt des Verpressens in mehrere Teilvorgänge aufzuteilen.

Gemäß einer weiteren vorteilhaften Ausgestaltung wird Schritt c) bei einer Temperatur von mindestens 20 °C durchgeführt. Besonders bevorzugt ist eine Temperatur von mindestens 150 °C, besonders bevorzugt von größer 250 °C, wobei die Temperatur insbesondere 800 °C oder alternativ 400 °C nicht überschreiten sollte. Insbesondere für die Materialien PbTE und BiTe hat sich eine Temperatur von mindestens 150 °C und höchstens 400 °C als besonders vorteilhaft erwiesen. Bevorzugt ist eine Verfahrensführung, bei der die Temperatur in einem Temperaturbereich von 30 bis 80 % der maximalen Temperaturbeständigkeit des thermoelektrischen Materials gehalten wird. Unter der maximalen Temperaturbeständigkeit wird die Temperatur verstanden, auf die das thermoelektrische Material erhitzt werden kann, wobei die thermoelektrischen Eigenschaften des Materials noch erhalten bleiben.

Bevorzugt erfolgt ein Erhitzen in Schritt c) durch induktive Beheizung, wobei die Verfahrensführung so erfolgt, dass der Strom etwa in der Tiefe der Grenzschicht zwischen dem thermoelektrischen Material und dem ersten und/oder zweiten Rahmenteil einkoppelt, insbesondere durch eine entsprechende Wahl der Frequenz der Anregung, so dass die Energieeinkopplung in einer entsprechenden Tiefe stattfindet.

Bevorzugt kann durch das Erhitzen der Grenzschicht zwischen thermoelektrischem Material und Rahmenteil und insbesondere unter Einsatz einer Beschichtung in diesem Bereich, beispielsweise aus Lot, ein eventuell durch die Grenzschicht und/oder eine unvollkommene stoffschlüssig Verbindung vorliegender Übergangswiderstand verringert werden und/oder die Haftung zwischen dem Rahmenteil und dem thermoelektrischen Material verbessert werden.

Bei derartigen Temperaturen kann auch ein vorgepresstes thermoelektrisches Material durch plastisches Fließen mit zumindest dem ersten Rahmenteil verbunden werden. Somit kann in besonders vorteilhafter Weise ein Sinterprozess realisiert werden, der eine hohe Verbindungsfestigkeit zwischen thermoelektrischem Material und erstem Rahmenteil bereits durch eine kraftschlüssige Verbindung ermöglicht. Diese Verbindung zwischen thermoelektrischen Material und erstem Rahmenteil ist insbesondere spaltfrei, so dass ein Wärmeübergang bzw. elektrischer Stromübergang nicht beeinträchtigt wird.

Weiterhin wird hier ein thermoelektrisches Modul vorgeschlagen, das zumindest zwei erfindungsgemäße Halbleiterelemente aufweist. Dabei sind die Halbleiterelemente in dem thermoelektrischen Modul so nebeneinander angeordnet, dass sich Rahmenteile benachbarter Halbleiterelemente kontaktieren und an dieser Kontaktierung stoffschlüssig miteinander verbunden sind. Insbesondere sind diese Kontaktierungen jeweils entweder elektrisch leitend oder elektrisch isolierend ausgeführt, so dass eine entsprechende elektrische Verschaltung der einzelnen Halbleiterelemente realisiert wird.

Selbstverständlich können auch Halbleiterelemente beider Ausgestaltungen gemeinsam in einem thermoelektrischen Modul entsprechend miteinander kombiniert werden. Ebenso kann die Kontaktierung mit ersten Rahmenteilen und/oder zweiten Rahmenteilen erfolgen.

Durch die Bereitstellung derartiger Halbleiterelemente, die direkt über Rahmenteile verbunden sind, wurde der bisher aufwendige und kostenintensive Herstellungsprozess eines thermoelektrischen Moduls deutlich vereinfacht. Insbesondere sind die sehr empfindlichen thermoelektrischen Materialien durch die Anordnung zwischen einem ersten Rahmenteil und einem zweiten Rahmenteil vor äußeren Einflüssen geschützt und können dementsprechend behandelt werden. Dabei werden die Rahmenteile benachbarter Halbleiterelemente so miteinander verbunden, dass ein elektrischer Stromfluss durch benachbart angeordnete Halbleiterelemente erzeugbar ist. Insbesondere ist verwirklicht, dass n- und p-dotierte Halbleiterelemente wechselweise hintereinander angeordnet sind, wobei deren Elementflächen, die jeweils einer Heißseite bzw. einer Kaltseite zugeordnet sind, wechselseitig elektrisch miteinander verbunden sind.

Gemäß einer weiteren vorteilhaften Ausgestaltung des thermoelektrischen Moduls kontaktieren sich Rahmenteile benachbarter Halbleiterelemente an jeweils einer Kontaktfläche und sind an dieser Kontaktierung stoffschlüssig miteinander verbunden. Insbesondere wird durch eine derartige Ausgestaltung ein Stumpfstoß zwischen den benachbart angeordneten Halbleiterelementen realisiert, so dass diese in besonders einfacher Art miteinander verschweißt, verlötet oder verklebt werden können. Alternativ oder zusätzlich kontaktieren Rahmenteile benachbarter Halbleiterelemente an jeweils einer Kontaktfläche und sind an dieser Kontaktierung elastisch miteinander verbunden, insbesondere durch eine entsprechende Vulkanisierung und/oder Gummierung.

Bevorzugt kann die Ausbildung einer stoffschlüssigen Verbindung benachbart angeordneter Halbleiterelement durch Schweißen, insbesondere durch Laserschweißen, erfolgen.

Weiterhin wird vorgeschlagen, dass bei dem thermoelektrischen Modul zumindest ein erstes Rahmenteil ein Kompensationselement bildet, so dass benachbart zueinander angeordnete Halbleiterelemente in zumindest einer Ebene zueinander bewegbar sind. Dieses Kompensationselement kann z. B. nach Art einer federnden Struktur vorgesehen sein, die zumindest mit dem ersten Rahmenteil gebildet wird. Durch das stoffschlüssige Verbinden der Rahmenteile benachbarter Halbleiterelemente werden somit Kompensationselemente gebildet, die eine Kompensation einer z. B. axialen Längenausdehnung einer Heißseite gegenüber einer Kaltseite und/oder einer Verschiebung der Halbleiterelemente zueinander in einer Umfangsrichtung und/oder in einer radialen Richtung ausgleichen. Selbstverständlich kann das zweite Rahmenteil ebenso ausgeführt sein.

Gemäß einer weiteren vorteilhaften Weiterentwicklung des thermoelektrischen Moduls ist zumindest ein erstes Rahmenteil unmittelbar mit einem heißen Medium wärmeleitend verbunden oder zumindest ein zweites Rahmenteil nur über eine elektrische Isolierung mit einem kalten Medium wärmeleitend verbunden. Ebenso können beide Merkmale gemeinsam vorgesehen sein.

Insbesondere wird hier als heißes Medium das Abgas einer Verbrennungskraftmaschine angesehen, das ein thermoelektrisches Modul überströmt. Insbesondere wird die dem Abgas zugewandte Oberfläche des thermoelektrischen Moduls zumindest durch eine Mehrzahl von ersten Rahmenteilen gebildet. Die ersten Rahmenteile sind untereinander in elektrisch leitender Weise stoffschlüssig miteinander verbunden. Wechselweise sind die Halbleiterelemente aber auch elektrisch gegeneinander isoliert ausgeführt, so dass der elektrische Strom wechselweise von einer Heißseite zu einer Kaltseite über n- und p-dotierte Halbleiterelemente geleitet wird. Die ersten Rahmenteile übernehmen hier die Funktion der Diffusionsbarriere gegenüber dem thermoelektrischen Material. Weiterhin erzeugen die ersten Rahmenteile einen elektrischen Strompfad entlang des thermoelektrischen Moduls und bilden dabei die Außenfläche des thermoelektrischen Moduls, die eine möglichst verlustarme Wärmeübertragung von einem heißen Medium auf die Halbleiterelemente ermöglichen soll. Da die zumindest ersten Rahmenteile somit das Gehäuse des thermoelektrischen Moduls an der Heißseite bilden, kann hier auf eine elektrische Isolierung der elektrisch leitenden ersten Rahmenteile gegenüber dem Abgas verzichtet werden. Dadurch wird der übliche Aufbau aus Gehäuse, elektrischer Isolierung, elektrisch leitenden Strompfaden, Diffusionsbarriere, thermoelektrischem Material signifikant vereinfacht. Die benachbart zueinander angeordneten Halbleiterelemente können insbesondere an ihren einander zugewandten Kontaktflächen elektrische Isolationselemente aufweisen, die eine Abdichtung des thermoelektrischen Moduls gegenüber dem Abgas ermöglichen und andererseits die ersten Rahmenteile gegeneinander elektrisch isolieren.

Entsprechend werden auch zweite Rahmenteile vorgeschlagen, die insbesondere das thermoelektrische Modul gegenüber einem kalten Medium abgrenzen. Das kalte Medium ist hier insbesondere eine Flüssigkeit. Eine elektrische Isolierung sollte gleichzeitig eine gute Wärmeleitung ermöglichen, so dass der Wirkungsgrad des thermoelektrischen Moduls hinsichtlich der Umwandlung von im Abgas enthaltener Wärmeenergie zu elektrischer Energie nicht eingeschränkt wird. Als elektrische Isolierung ist z. B. eine Folie vorgesehen, die in einfacher Weise auf die entsprechende Oberfläche des thermoelektrischen Moduls aufgebracht werden kann. Alternativ oder zusätzlich kann als elektrische Isolierung ein Schrumpfschlauch, insbesondere auf der dem kalten Medium zugewandten Seite der zweiten Rahmenteile vorgeschlagen werden. Eine elektrische Isolierung kann auf den Rahmenteilen außen und/oder innen aufgetragen sein, insbesondere außen, bevorzugt in den die Außenfläche des thermoelektrischen Moduls bildenden Bereichen der Rahmenteile.

Insbesondere bilden bei einer derartigen Ausgestaltung des thermoelektrischen Moduls die ersten und/oder zweiten Rahmenteile, die jeweils insbesondere mit Kompensationselementen ausgeführt sind, gleichzeitig vergrößerte Wärmeübertragungsflächen. Diese vergrößerten Wärmeübertragungsflächen werden insbesondere dadurch erreicht, dass die miteinander über Kontaktflächen verbundenen Rahmenteile zumindest teilweise in den Abgasstrom bzw. in das kalte Medium hineinragen. Dadurch wird einerseits eine Turbulenz des Abgases bzw. des kalten Mediums erzeugt, so dass ein verbesserter Wärmeübergang die Folge ist, und gleichzeitig eine gute Durchmischung des Abgases bzw. des kalten Mediums erreicht, so dass ein möglichst gleichmäßiges Temperaturniveau am thermoelektrischen Modul vorliegt.

Die hier vorgeschlagenen Halbleiterelemente und thermoelektrischen Module sind insbesondere für thermoelektrische Generatoren geeignet, die für Kraftfahrzeuge verwendet werden, und die die Wärmeenergie eines Abgases einer Verbrennungskraftmaschine in elektrische Energie umwandeln sollen.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Es zeigen schematisch:
- Fig. 1:: ein Halbleiterelement;
- Fig. 2:: ein erstes Rahmenteil;
- Fig. 3:: ein zweites Rahmenteil;
- Fig. 4:: ein thermoelektrisches Modul;
- Fig. 5:: eine erste Anordnung von Halbleiterelementen;
- Fig. 6:: eine zweite Anordnung von Halbleiterelementen;
- Fig. 7:: den Verfahrensschritt a) zur Herstellung eines Halbleiterelements;
- Fig. 8:: einen Schritt b) des Verfahrens zur Herstellung eines Halbleiterelements, und
- Fig. 9:: einen Schritt c) zur Herstellung eines Halbleiterelements.

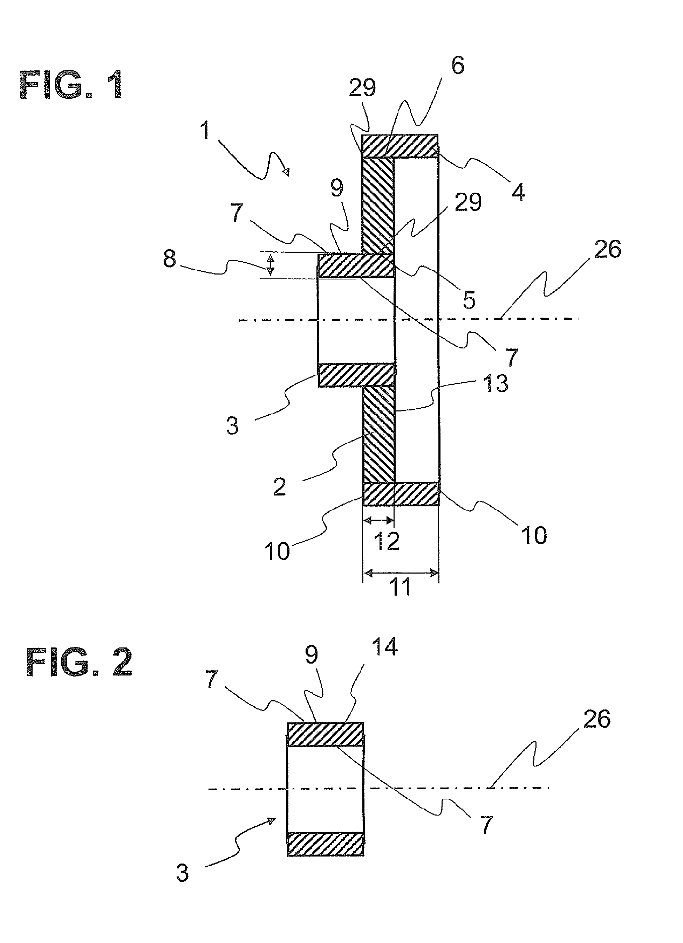

Fig. 1 zeigt ein ringförmiges Halbleiterelement 1 mit einem thermoelektrischen Material 2 und einem auf der inneren Umfangsfläche 5 des thermoelektrischen Materials 2 angeordneten ersten Rahmenteil 3. Auf der äußeren Umfangsfläche 6 des thermoelektrischen Materials 2 ist ein zweites Rahmenteil 4 angeordnet. Auch wenn hier die Bezeichnung "erstes Rahmenteil" für das innere Rahmenteil und die Bezeichnung "zweites Rahmenteil" für das äußere Rahmenteil verwendet wird, ist eine solche Zuordnung nicht zwingend für andere Ausführungsvarianten der Erfindung.

Die äußere Umfangsfläche 6 ist die Elementfläche 29 des thermoelektrischen Materials 2, die der Elementfläche 29 des thermoelektrischen Materials 2 gegenüberliegt, an der dieses mit dem ersten Rahmenteil 3 verbunden ist. Das erste Rahmenteil 3 weist zwei gegenüberliegende Flächen 7 auf, wobei an der dem thermoelektrischen Material 2 gegenüberliegenden Fläche 7 eine Anbindungsfläche 9 gebildet ist. Zwischen den gegenüberliegenden Flächen 7 wird eine Dicke 8 des ersten Rahmenteils 3 gebildet. Das zweite Rahmenteil 4 weist zwei einander gegenüberliegende Kontaktflächen 10 auf, zwischen denen sich eine erste Breite 11 des zweiten Rahmenteils 4 erstreckt. In einer entsprechenden parallelen Richtung weist das thermoelektrische Material 2 eine zweite Breite 12 auf, die hier geringer ist als die erste Breite 11. Entsprechend steht das erste Rahmenteil 3 in Richtung der Mittelachse 26 über das thermoelektrische Material 2 an einer Seite 13 des thermoelektrischen Materials 2 über. Ein entsprechender Überstand über das thermoelektrische Material 2 bildet sich in einer entgegen gesetzten Richtung gegenüber dem zweiten Rahmenteil 4 auch am ersten Rahmenteil 3 in Richtung der Mittelachse 26 aus.

Fig. 2 zeigt ein ringförmiges erstes Rahmenteil 3 mit zwei einander gegenüberliegenden Flächen 7, wobei hier die äußere Fläche 7 eine Anbindungsfläche 9 bildet zur Anbindung des ersten Rahmenteils 3 an das thermoelektrische Material. Dabei ist zur Erhöhung der Verbindungsfestigkeit zwischen erstem Rahmenteil 3 und thermoelektrischen Material 2 eine Beschichtung 14 vorgesehen, die auf der Anbindungsfläche 9 aufgetragen ist.

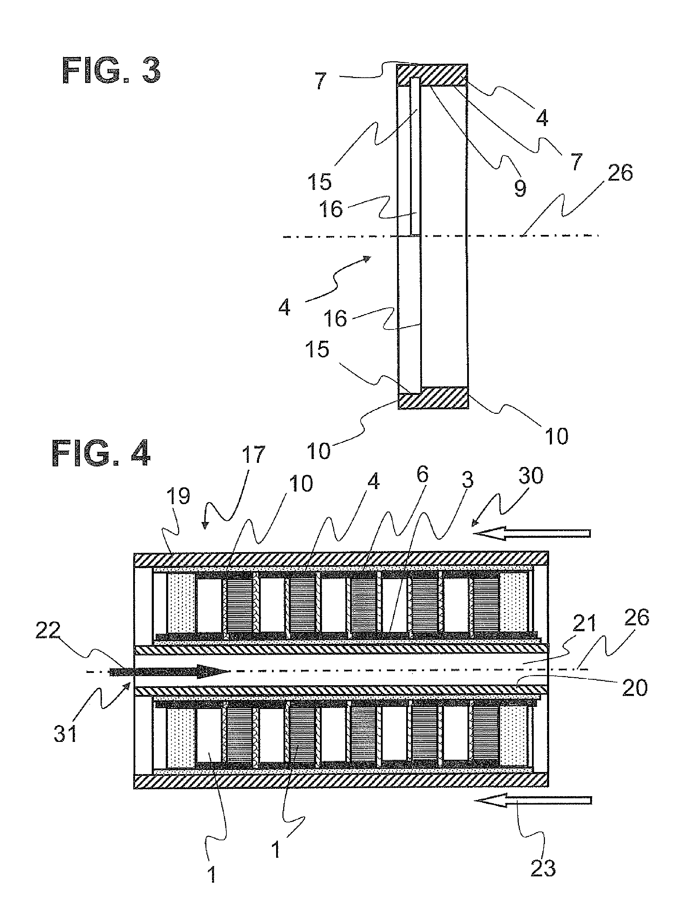

Fig. 3 zeigt ein zweites Rahmenteil 4 mit entsprechenden einander gegenüberliegenden Flächen 7, wobei hier die innere Umfangsfläche des ringförmigen zweiten Rahmenteils 4 die Anbindungsfläche 9 zur Anbindung des zweiten Rahmenteils 4 an das thermoelektrische Material aufweist. Auf der Anbindungsfläche 9 ist im oberen Teil der Fig. 3 ein Element 16 als Oberflächenstruktur 15 dargestellt, das hier als Nut ausgeführt ist. In diese Nut hinein erstreckt sich das thermoelektrische Material, so dass es zumindest in Richtung der Mittelachse 26 innerhalb des ringförmigen zweiten Rahmenteils 4 fixiert ist. Das thermoelektrische Material kann sich dabei in Richtung der Mittelachse 26 beidseitig der Nut innerhalb des zweiten Rahmenteils 4 erstrecken. In der unteren Hälfte der Fig. 3 wird die Oberflächenstruktur 15 durch das Element 16 gebildet,
dass hier als Absatz dargestellt ist, das zumindest in einer Richtung der Mittelachse 26 eine Fixierung des thermoelektrischen Materials erlaubt.
Das thermoelektrische Material ist zwischen der ringförmigen Anbindungsfläche 9 und den seitlichen Kontaktflächen 10 angeordnet.

Fig. 4 zeigt ein thermoelektrisches Modul 17 mit einer Vielzahl von Halbleiterelementen 1. Diese Halbleiterelemente 1 sind ringförmig um ein Innenrohr 20 angeordnet und werden auf einer äußeren Umfangsfläche 6 durch ein Außenrohr 19 umschlossen. Das Innenrohr 20 bildet einen Kanal 21, durch den ein heißes Medium 22 entlang der Mittelachse 26 strömt. Auf der äußeren Umfangsfläche des Außenrohrs 19 wird das thermoelektrische Modul 17 von einem kalten Medium 23 überströmt.

Dadurch bildet sich zwischen Außenrohr 19 und Innenrohr 20 ein Temperaturpotential aus, so dass durch die wechselweise auf der Kaltseite 30 bzw. Heißseite 31 elektrisch miteinander verbundenen Halbleiterelemente 1 ein elektrischer Strom durch das thermoelektrische Modul 17 in Folge des thermoelektrischen Effekts erzeugbar wird. An den Kontaktflächen 10 sind zweite Rahmenteile 4 bzw. erste Rahmenteile 3 miteinander elektrisch leitend verbunden.

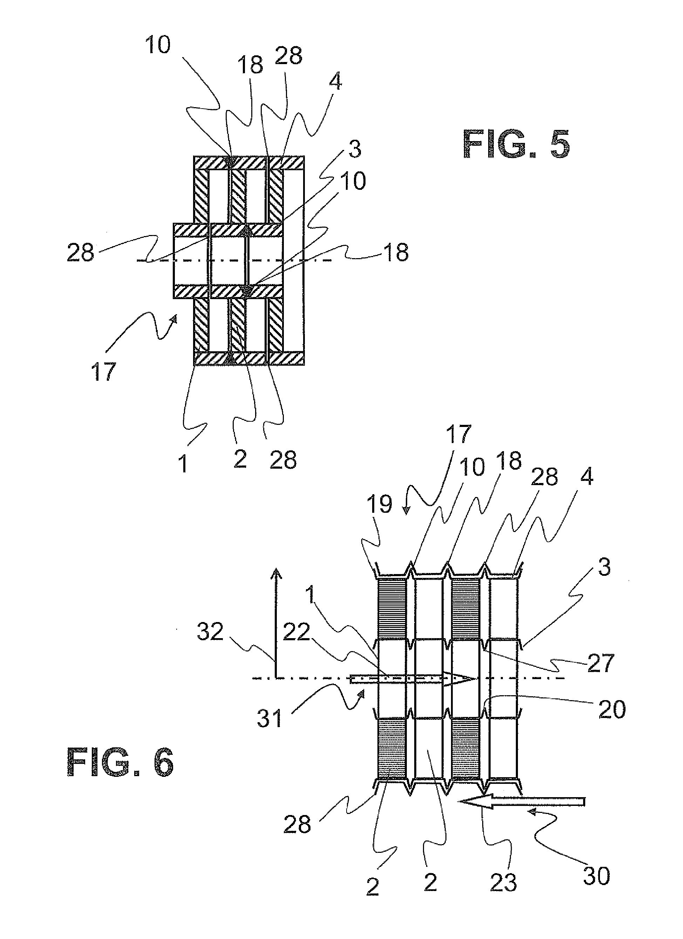

Fig. 5 zeigt eine erste Anordnung von Halbleiterelementen 1 zu einem thermoelektrischen Modul 17. Die hier entsprechend Fig. 1 aufgebauten Halbleiterelemente 1 sind wechselweise über erste Rahmenteile 3 bzw. zweite Rahmenteile 4 an Kontaktflächen 10 miteinander stoffschlüssig verbunden, so dass jeweils eine Kontaktierung 18 gebildet ist. Entsprechend sind wechselweise zwischen jeweils benachbarten ersten Rahmenteilen 3 und jeweils benachbarten zweiten Rahmenteilen 4 elektrische Isolierungen 28 vorgesehen, die einen entsprechenden Strompfad durch das thermoelektrische Modul 17 erzeugen.

Fig. 6 zeigt eine zweite Anordnung von Halbleiterelementen 1 zu einem thermoelektrischen Modul 17. Dabei sind n- und p-dotierte thermoelektrische Materialien 2 über erste Rahmenteile 3 bzw. zweite Rahmenteile 4 über Kontaktflächen 10 elektrisch leitend miteinander verbunden bzw. an den Kontaktflächen 10 voneinander isoliert. Die sich berührenden Kontaktflächen 10 bilden also jeweils Kontaktierungen 18. Das thermoelektrische Modul 17 wird hier direkt auf der äußeren Oberfläche des thermoelektrischen Moduls 17, die durch die zweiten Rahmenteile 4 gebildet wird, von einem kalten Medium 23 überströmt. Die ringförmig umlaufend ausgebildeten und in einer radialen Richtung nach außen aufstehenden zweiten Rahmenteile 4 sind an Kontaktflächen 10 miteinander wechselweise elektrisch leitend oder elektrisch isoliert verbunden und bilden somit ein zusammenhängendes Außenrohr 19. Entsprechend bilden auf der Innenseite des thermoelektrischen Moduls 17 die ersten Rahmenteile 3 das innere Rohr 20, das von einem heißen Medium 22 durchströmt wird. Da das heiße Medium 22 regelmäßig ein Abgas ist, kann hier auf der Heißseite 31 auf eine elektrische Isolierung der ersten Rahmenteile 3 gegenüber dem Abgas verzichtet werden. Auf der Kaltseite 30 ist bei Verwendung eines elektrisch leitenden kalten Mediums 23 eine elektrische Isolierung 28 erforderlich, die außen auf den zweiten Rahmenteilen 4 aufgebracht ist. Diese kann beispielsweise als Schrumpfschlauch ausgebildet sein. Durch die nach außen bzw. innen aufstehenden Rahmenteile 3, 4 werden Kompensationselemente 27 gebildet, die eine Wärmeausdehnung des thermoelektrische Moduls 17 in Richtung der Mittelachse 26 ermöglicht. Gleichzeitig wird auch eine relative Verschiebung der Halbleiterelemente 1 zueinander in einer radialen Richtung 32 ermöglicht.

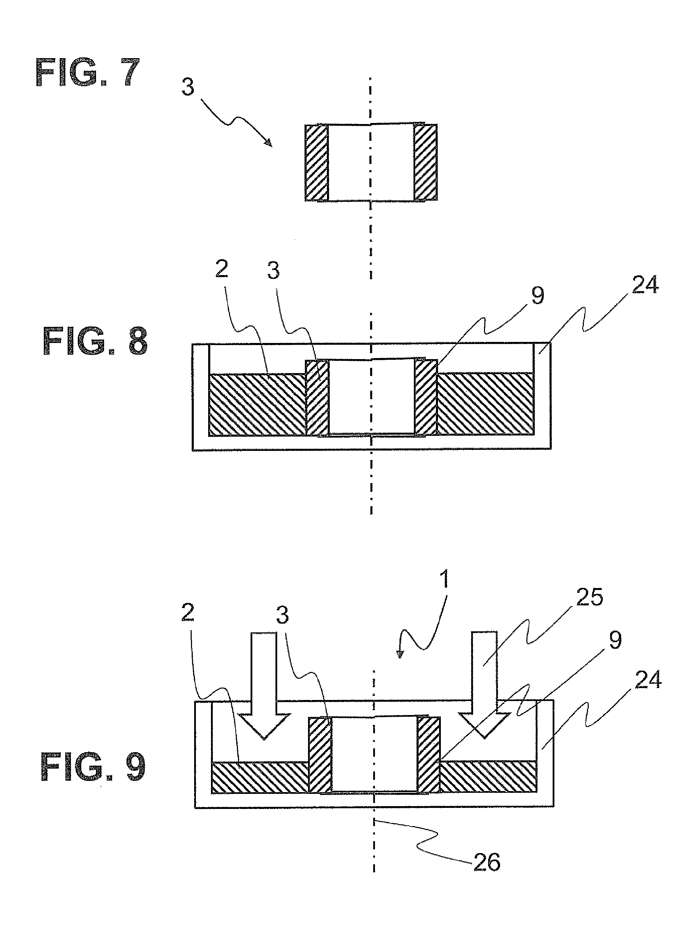

Fig. 7 zeigt den Verfahrensschritt a) zur Herstellung eines Halbleiterelements, wobei ein erstes Rahmenteil 3 bereitgestellt wird.

Fig. 8 zeigt einen Schritt b) des Verfahrens zur Herstellung eines Halbleiterelements, wobei auf der Anbindungsfläche 9 des ersten Rahmenteils 3 ein thermoelektrisches Material 2 angeordnet ist. Erstes Rahmenteil 3 und thermoelektrisches Material 2 sind dazu in einer Form 24 angeordnet.

Fig. 9 zeigt einen Schritt c) zur Herstellung eines Halbleiterelements 1, wobei das in der Form 24 angeordnete thermoelektrische Material 2 durch einen in Richtung der Mittelachse 26 bewegbaren Stempel 25 verdichtet wird und sich infolge des aufgebrachten Drucks mit dem ersten Rahmenteil 3 zumindest kraftschlüssig verbindet. Dabei kann zusätzlich Wärme in den Pressprozess eingebracht werden, so dass auch ein bereits vorgepresstes thermoelektrisches Material 2 plastisch zu fließen beginnt und sich mit dem ersten Rahmenteil 3 über die Anbindungsfläche 9 zumindest kraftschlüssig verbindet. Durch das Verpressen von thermoelektrischen Material 2 und erstem Rahmenteil 3 wird eine spaltfreie Verbindung dieser Bauteile zu einem Halbleiterelement 1 möglich.

Mit der hier vorliegenden Erfindung wurden die im Bezug auf den Stand der Technik geschilderten Probleme zumindest teilweise gelöst. Insbesondere wurde ein Halbleiterelement angegeben, das für vielseitige Einsatzfälle geeignet ist, und das einen möglichst einfachen und kostengünstigen Aufbau eines thermoelektrischen Moduls ermöglicht. Zudem wurde ein einfaches Verfahren zur Herstellung eines solchen Halbleiterelements angegeben.

### Bezugszeichenliste

- 1: Halbleiterelement
- 2: thermoelektrisches Material
- 3: erstes Rahmenteil
- 4: zweites Rahmenteil
- 5: innere Umfangsfläche
- 6: äußere Umfangsfläche
- 7: Fläche
- 8: Dicke
- 9: Anbindungsfläche
- 10: Kontaktfläche
- 11: erste Breite
- 12: zweite Breite
- 13: Seite
- 14: Beschichtung
- 15: Oberflächenstruktur
- 16: Element
- 17: thermoelektrisches Modul
- 18: Kontaktierung
- 19: Außenrohr
- 20: Innenrohr
- 21: Kanal
- 22: heißes Medium
- 23: kaltes Medium
- 24: Form
- 25: Stempel
- 26: Mittelachse
- 27: Kompensationselement
- 28: elektrische Isolierung
- 29: Elementfläche
- 30: Kaltseite
- 31: Heißseite
- 32: radiale Richtung

## Patentansprüche

1. Halbleiterelement (1) zumindest aufweisend ein thermoelektrisches Material (2) und ein erstes Rahmenteil (3), die kraftschlüssig miteinander verbunden sind, wobei das erste Rahmenteil (3) eine Diffusionsbarriere für das thermoelektrische Material (2) und einen elektrischen Stromleiter bildet, sowie mit einem zweiten Rahmenteil (4) das auf einer Elementfläche (29) des thermoelektrischen Materials (2) angeordnet ist, die der Elementfläche (29) gegenüberliegt, an der das erste Rahmenteil (3) angeordnet ist, **dadurch gekennzeichnet daß**, das thermoelektrische Material (2), das erste Rahmenteil (3) und das zweite Rahmenteil (4) ringförmig sind und das erste Rahmenteil (3) auf einer inneren Umfangsfläche (5) und das zweite Rahmenteil (4) auf einer äußeren Umfangsfläche (6) des thermoelektrischen Materials (2) angeordnet sind.

2. Halbleiterelement (1) gemäß Patentanspruch 1, wobei zumindest das erste Rahmenteil (3) zwei voneinander beabstandete gegenüberliegende Flächen (7) aufweist, wobei eine der Flächen (7) eine dem thermoelektrischen Material (2) zugewandte Anbindungsfläche (9) ist, wobei der Abstand der Flächen (7) voneinander eine Dicke (8) des ersten Rahmenteils (3) definiert, wobei die Dicke (8) 0,1 mm bis 1 mm beträgt.

3. Halbleiterelement (1) nach einem der vorhergehenden Patentansprüche, wobei zumindest das erste Rahmenteil (3) zwei voneinander beabstandete gegenüberliegende Kontaktflächen (10) aufweist, deren Abstand eine erste Breite (11) definiert, wobei die erste Breite (11) zumindest teilweise größer ist als eine zweite Breite (12) des thermoelektrischen Materials (2), so dass das erste Rahmenteil (3) an zumindest einer Seite (13) des thermoelektrischen Materials (2) übersteht.

4. Halbleiterelement (1) nach einem der vorhergehenden Patentansprüche, wobei zumindest das erste Rahmenteil (3) eine Beschichtung (14) aufweist, die zumindest auf der dem thermoelektrischen Material (2) zugewandten Anbindungsfläche (9) angeordnet ist.

5. Halbleiterelement (1) nach Anspruch 4, bei dem die Beschichtung (14) ein Lot umfasst.

6. Halbleiterelement (1) nach einem der vorhergehenden Patentansprüche, wobei zumindest das erste Rahmenteil (3) zumindest auf der dem thermoelektrischen Material (2) zugewandten Anbindungsfläche (9) wenigstens teilweise eine Oberflächenstruktur (15) aufweist, die mindestens eines der folgenden Elemente (16) umfasst:
- Nut,
- Absatz,
- Erhebung,
- Rauhigkeit (Rz) von mindestens 12 µm.

7. Halbleiterelement (1) nach einem der vorhergehenden Patentansprüche, wobei zumindest das erste Rahmenteil (3) zu mindestens 95 Massen-% aus Nickel oder Molybdän besteht.

8. Thermoelektrisches Modul (17) aufweisend zumindest zwei Halbleiterelemente (1) gemäß einem der Patentansprüche 1 bis 7, wobei die Halbleiterelemente (1) so nebeneinander angeordnet sind, dass sich Rahmenteile benachbarter thermoelektrischer Elemente (1) kontaktieren und an dieser Kontaktierung (18) stoffschlüssig miteinander verbunden sind.

9. Thermoelektrisches Modul (17) gemäß Patentanspruch 8, wobei sich Rahmenteile benachbarter Halbleiterelemente (1) an jeweils einer Kontaktfläche (10) kontaktieren und an dieser Kontaktierung (18) stoffschlüssig miteinander verbunden sind.

10. Thermoelektrisches Modul (17) gemäß einem der Patentansprüche 8 oder 9, wobei zumindest ein erstes Rahmenteil (3) ein Kompensationselement (27) bildet, so dass benachbart zueinander angeordnete Halbleiterelemente (1) in zumindest einer Ebene zueinander bewegbar sind.

11. Thermoelektrisches Modul (17) gemäß einem der Patentansprüche 8 bis 10, wobei zumindest das erste Rahmenteil (3) unmittelbar mit einem heißen Medium (22) wärmeleitend verbunden ist oder zumindest das zweites Rahmenteil (4) nur über eine elektrische Isolierung (28) mit einem kalten Medium (23) wärmeleitend verbunden ist.

## Claims

1. Semiconductor element (1) having at least a thermoelectric material (2) and a first frame part (3), which are connected non-positively to one another, wherein the first frame part (3) forms a diffusion barrier for the thermoelectric material (2) and an electric conductor; further having a second frame part (4), which is arranged on an element surface (29) of the thermoelectric material (2) which lies opposite the element surface (29) on which the first frame part (3) is arranged; **characterized in that** the thermoelectric material (2), the first frame part (3) and the second frame part (4) are annular, and the first frame part (3) is arranged on an inner circumferential surface (5) and the second frame part (4) is arranged on an outer circumferential surface (6) of the thermoelectric material (2).

2. Semiconductor element (1) as claimed in claim 1, wherein at least the first frame part (3) has two mutually opposite spaced surfaces (7), wherein one of the surfaces (7) is an attachment surface (9) facing the thermoelectric material (2), wherein the spacing between the surfaces (7) defines a thickness (8) of the first frame part (3), wherein the thickness (8) is 0.1 mm to 1 mm.

3. Semiconductor element (1) as claimed in one of the preceding claims, wherein at least the first frame part (3) has two mutually opposite spaced contact surfaces (10), the spacing between which defines a first width (11), wherein the first width (11) is at least in part greater than a second width (12) of the thermoelectric material (2), with the result that the first frame part (3) projects on at least one side (13) of the thermoelectric material (2).

4. Semiconductor element (1) as claimed in one of the preceding claims, wherein at least the first frame part (3) has a coating (14) which is arranged at least on the attachment surface (9) facing the thermoelectric material (2).

5. Semiconductor element (1) as claimed in claim 4, in which the coating (14) comprises a solder.

6. Semiconductor element (1) as claimed in one of the preceding claims, wherein, at least on the attachment surface (9) facing the thermoelectric material (2), at least the first frame part (3) has, at least in part, a surface structure (15) which comprises at least one of the following elements (16):
- groove,
- offset,
- raised portion,
- roughness (Rz) of at least 12 µm.

7. Semiconductor element (1) as claimed in one of the preceding claims, wherein at least the first frame part (3) is composed of at least 95% by weight of nickel or molybdenum.

8. Thermoelectric module (17) having at least two semiconductor elements (1) as claimed in one of claims 1 to 7, wherein the semiconductor elements (1) are arranged adjacent to one another in such a way that frame parts of adjacent thermoelectric elements (1) are in contact and are connected to one another materially at this contact location (18).

9. Thermoelectric module (17) as claimed in claim 8, wherein frame parts of adjacent semiconductor elements (1) are in each case in contact at a contact surface (10) and are connected to one another materially at this contact location (18).

10. Thermoelectric module (17) as claimed in one of claims 8 or 9, wherein at least a first frame part (3) forms a compensation element (27), with the result that semiconductor elements (1) arranged adjacent to one another can be moved relative to one another in at least one plane.

11. Thermoelectric module (17) as claimed in one of claims 8 to 10, wherein at least the first frame part (3) is connected directly in a thermally conductive manner to a hot medium (22), or at least the second frame part (4) is connected in a thermally conductive manner only via an electric insulation (28) to a cold medium (23).

## Revendications

1. Elément semi-conducteur (1) présentant au moins un matériau thermoélectrique (2) et une première partie de cadre (3), qui sont assemblés l'un à l'autre par friction, dans lequel la première partie de cadre (3) forme une barrière de diffusion pour le matériau thermoélectrique (2) et un conducteur de courant électrique, ainsi qu'avec une deuxième partie de cadre (4) qui est disposée sur une face élémentaire (29) du matériau thermoélectrique (2), qui est opposée à la face élémentaire (29) sur laquelle la première partie de cadre (3) est disposée, **caractérisé en ce que** le matériau thermoélectrique (2), la première partie de cadre (3) et la deuxième partie de cadre (4) sont annulaires et la première partie de cadre (3) est disposée sur une face périphérique intérieure (5) et la deuxième partie de cadre (4) est disposée sur une face périphérique extérieure (6) du matériau thermoélectrique (2).

2. Elément semi-conducteur selon la revendication 1, dans lequel au moins la première partie de cadre (3) présente deux faces opposées (7) espacées l'une de l'autre, dans lequel une des faces (7) est une face de liaison (9) tournée vers le matériau thermoélectrique (2), dans lequel la distance des faces (7) l'une de l'autre définit une épaisseur (8) de la première partie de cadre (3), l'épaisseur (8) valant 0,1 mm à 1 mm.

3. Elément semi-conducteur (1) selon l'une quelconque des revendications précédentes, dans lequel au moins la première partie de cadre (3) présente deux faces de contact opposées (10) espacées l'une de l'autre, dont la distance définit une première largeur (11), dans lequel la première largeur (11) est au moins en partie plus grande qu'une deuxième largeur (12) du matériau thermoélectrique (2), de telle manière que la première partie de cadre (3) soit saillante sur au moins un côté (13) du matériau thermoélectrique (2).

4. Elément semi-conducteur (1) selon l'une quelconque des revendications précédentes, dans lequel au moins la première partie de cadre (3) présente un revêtement (14), qui est disposé au moins sur la face de liaison (9) tournée vers le matériau thermoélectrique (2).

5. Elément semi-conducteur (1) selon la revendication 4, dans lequel le revêtement (14) comprend une brasure.

6. Elément semi-conducteur (1) selon l'une quelconque des revendications précédentes, dans lequel au moins la première partie de cadre (3) présente au moins sur la face de liaison (9) tournée vers le matériau thermoélectrique (2) au moins en partie une structure de surface (15), qui comprend au moins un des éléments suivants (16):
- rainure,
- épaulement,
- surélévation,
- rugosité (Rz) d'au moins 12 µm.

7. Elément semi-conducteur (1) selon l'une quelconque des revendications précédentes, dans lequel au moins la première partie de cadre (3) se compose à raison d'au moins 95 % en masse de nickel ou de molybdène.

8. Module thermoélectrique (17) présentant au moins deux éléments semi-conducteurs (1) selon l'une quelconque des revendications 1 à 7, dans lequel les éléments semi-conducteurs (1) sont disposés l'un à côté de l'autre, de telle manière que des parties de cadre d'éléments semi-conducteurs voisins (1) soient en contact et soient matériellement assemblées l'une à l'autre à cet endroit de contact (18).

9. Module thermoélectrique (17) selon la revendication 8, dans lequel des parties de cadre d'éléments semi-conducteurs voisins (1) sont en contact par une face de contact respective et sont matériellement assemblées l'une à l'autre à cet endroit de contact (18).

10. Module thermoélectrique (17) selon l'une quelconque des revendications 8 ou 9, dans lequel au moins une première partie de cadre (3) forme un élément de compensation (27), de telle manière que des éléments semi-conducteurs (1) disposés au voisinage l'un de l'autre soient déplaçables l'un vers l'autre dans au moins un plan.

11. Module thermoélectrique (17) selon l'une quelconque des revendications 8 à 10, dans lequel au moins la première partie de cadre (3) est en liaison conductrice de chaleur directement avec un fluide chaud (22) ou au moins la deuxième partie de cadre (4) n'est en liaison conductrice de chaleur avec un fluide froid (23) que via un isolant électrique (28).
